# EUROPEAN PATENT APPLICATION

(11) **EP 0 881 511 A2**
(43) Date of publication of application: **02.12.1998**
(21) Application number: 98107562.5
(22) Date of filing: 24.04.1998
(51) Int. Cl.: G02B 6/12, H01S 3/25, H01S 3/025, H01S 3/19, G02F 1/313

(54) **Active multimode optical signal splitter**

(30) Priority: 30.05.1997 US 866656
(71) Applicant: TRW Inc., Redondo Beach, California 90278 (US)
(72) Inventor: Zmudzinski, Charles A., Redondo Beach, California 90277 (US)
(74) Representative: Schmidt, Steffen J., Dipl.-Ing.

(57) **Abstract**

An active optical signal splitter compensates for optical signal splitting losses. The active optical signals splitter includes an active multimode waveguide which provides splitting and amplification of an input optical signal and a plurality of integrated single mode waveguides. The single mode waveguides may be formed with both active and passive waveguide regions. Pumping current may be applied to the active single mode waveguide region to provide individual amplitude control of the N output optical signals. By providing optical amplification and splitting of the input optical signal in the active multimode waveguide, losses resulting from optical losses due to signal splitting can be compensated to enable optical signal splitting from 1 to N with virtually no losses.

## Description

### BACKGROUND OF THE INVENTION

### 1. Technical Field

The present invention relates to optical signal splitter and more particularly to an active multimode optical signal splitter which includes an optical multimode waveguide which allows for signal splitting and current pumping in order to provide optical power amplification in order to minimize optical losses due to signal splitting and a waveguide portion which includes a passive region and may include an active region to provide for current pumping to provide individual amplitude control of the N output signals.

### 2. Description of the Prior Art

Photonic devices are known to be used for various applications including antenna systems, such as phased array antenna systems, for providing beam steering of a radiation pattern. Such phased array antennas, for example, as disclosed in U.S. Patent Nos. 5,162,803 and 5,579,016, hereby incorporated by reference, normally include a plurality of antenna elements configured in an array. In such systems, an RF modulated optical signal is split into a plurality of component optical signals which, in turn, feed the individual antenna elements in the array. The component optical signals fed to each of the antenna elements are delayed either by time delay or phase delay so as to result in beam steering of the radiation pattern irradiating from the antenna elements.

The light weight, small size and mechanical compliance of photonic elements, such as optical waveguides, provide relatively low transmission loss, wide bandwidth, and negligible RF dispersion. Recent technical advances have improved RF performance of optical modulators and demodulators for use with such phased array antenna systems for higher frequencies and wider bandwidths.

Passive optical signal splitters, for example as disclosed in U.S. Patent No. 5,410,625, are known to be used in various applications including phased array antenna systems. Unfortunately, such passive optical signal splitters are generally not suitable for applications sensitive to signal to noise ratio degradation due to relatively large RF signal attenuation that normally accompanies optical signal splitting. More particularly, in such a system, an optical carrier is modulated by an RF voltage. Splitting the optical carrier N times causes a 1/N² reduction in the RF signal power, a factor of 1/N greater than the corresponding effect for a conventional RF distribution system. Despite the increased RF splitting loss in large optical distribution systems, a significant reduction in propagation losses in optical waveguides relative to electrical microstrip waveguides results in a net reduction of the losses for many systems, making such optical systems more desirable especially if high bandwidth and low size and weight are desired.

Unfortunately, the losses associated with such optical signal splitters necessitate preamplification. However, preamplification of the input signal is limited by the saturation power which approximates the upper limit on the maximum optical power before RE gain is reduced. To minimize the effect of signal shot noise, a signal is normally about 10 milliwatts or higher. If an optical preamplifier is used to compensate for splitting losses of a passive device, the output levels are known to be limited to a value of approximately 1/N times the saturation power for a 1 by N splitter in order to prevent driving the preamplifier too strongly into saturation. However, this would require that the saturation power be N x 10 milliwatts to maintain the 10 milliwatts signal output levels.

### SUMMARY OF THE INVENTION

It is an object of the present invention to solve various problems in the prior art.

It is yet another object of the present invention to provide an optical signal splitter which reduces splitting losses.

Briefly the present invention relates to an active multimode optical signal splitter which compensates for optical signal splitting losses. The active multimode optical signal splitter includes an optical multimode waveguide, which allows for signal splitting and current pumping in order to provide optical power amplification in order to minimize optical losses due to signal splitting, and a plurality of single mode waveguides. The single mode waveguides may be formed with both active and passive waveguide regions.

Pumping current is applied to the active multimode waveguide to simultaneously provide optical amplification and splitting, and, for an embodiment with an active region in the output waveguides, pumping current may also be applied to each active output waveguide to provide individual amplitude control of the N output signals. By providing optical amplification in the multimode optical waveguide, the benefit of optical preamplification is obtained, without the penalty of a required increase in the saturation power from about 10 mW to N x 10 mW. Splitting losses can be compensated to enable optical signal splitting from 1 to N with virtually no losses.

### DESCRIPTION OF THE DRAWINGS

These and other objects of the present invention will be readily understood with reference to the following specification and attached drawing wherein:
FIG. 1 is a schematic diagram of an exemplary 1 x N an active multimode optical signal splitter in accordance with the present invention.
FIGS. 2a and 2b illustrate sectional views of the active multimode optical signal splitter in accordance with the present invention showing the different steps in the fabrication process.
FIG. 3 is a perspective view of a known passive multimode splitter.

### DETAILED DESCRIPTION

The present invention relates to an active multimode optical signal splitter based on the symmetric mode self-imaging effect. Optical splitting from 1 to N output signals is achieved in a multimode waveguide of length equal to 1/N (Λ), where Λ is the symmetric mode self-imaging distance as described In: "Novel 1 to N Way Integrated Optical Beam Splitters Using Symmetric Mode Mixing in GaAs/AlGaAs Multimode Waveguides", by J.M. Heatan, R.M. Jenkins, D.R. Wright, J.T. Parker, J.C.H. Birbeck and K.P. Hilton, Appl. Phys. Lett., Vol. 61, No. 15, pp. 1754-1756, 1992. The output of the multimode waveguide is adapted to be monolithically coupled to N single mode waveguides that fan out to a spacing of, for example 50 micrometers on a semiconductor chip. An important aspect of the invention relates to the active multimode waveguide which allows for signal splitting and allows for current pumping to provide upfront optical amplification to provide optical power gain as generally described in U.S. Patent No. 5,539,571 and 5,414,554, hereby incorporated by reference. The active multimode optical signal splitter also includes single mode waveguides which may be formed as passive waveguides or with both active and passive regions. The active regions of the single mode waveguides may include electrical contacts in order to provide individual amplitude control of the output signals from the multimode waveguides. As such, the active multimode optical signal splitter is adapted to provide optical signal splitting from 1 to N output signals with virtually no losses due to signal splitting.

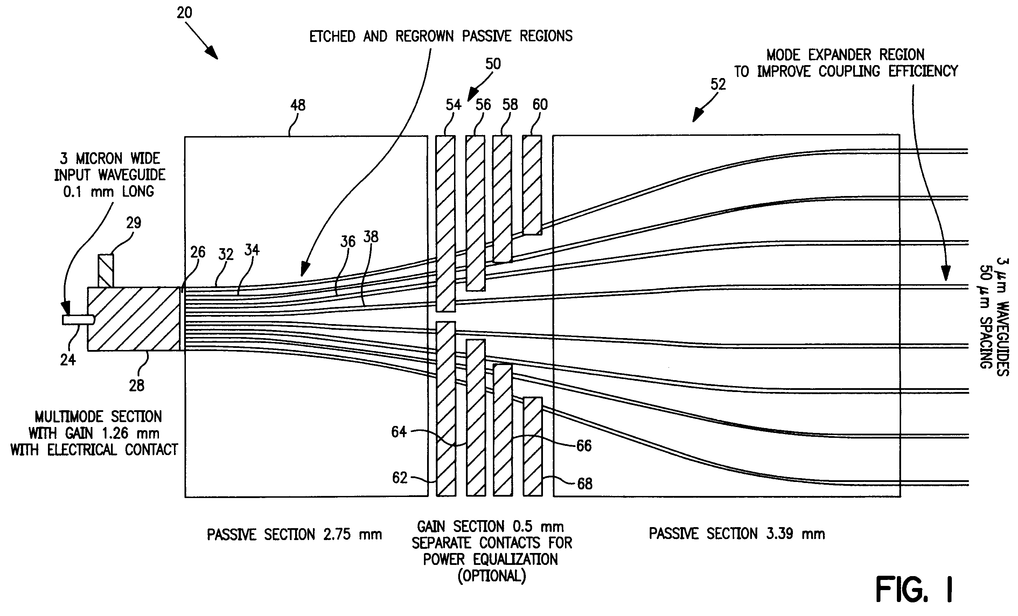

An exemplary embodiment of the optical signal splitter in accordance with the present invention, generally identified with the reference 20, is illustrated in FIG. 1. Although the optical signal splitter 20 is shown as a 1 x 8 optical signal splitter, it should be understood by those of ordinary skill in the art that the principles of the present invention are applicable to various types of signal splitters other than that is shown and described. Moreover, the dimensions of the optical signal splitter 20 shown and described are exemplary for operation at an optical wavelength of 1.3 microns in a InP/InGaAsP semiconductor material.

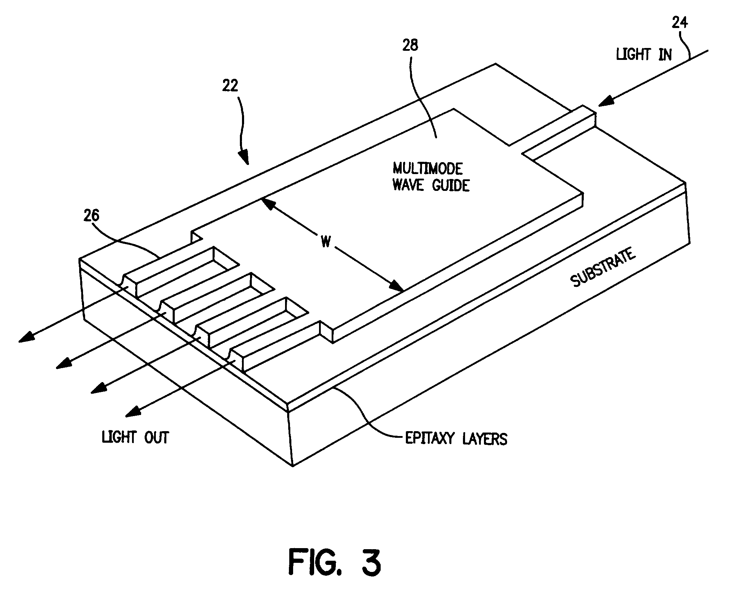

Referring to FIG. 1, the optical signal splitter 20, as will be discussed in more detail below, is adapted to be monolithically fabricated on a semiconductor substrate, such as InP. The optical signal splitter includes a multimode waveguide 28, which provides 1 to N splitting of an input optical signal. Passive multimode waveguides as shown in FIG. 3, are generally known in the art and are disclosed in: "Novel 1 to N Way Integrated Optical Beam Splitters Using Symmetric Mode Mixing in GaAs/AlGaAs Multimode Waveguides", by J.M. Heatan, R.M. Jenkins, D.R. Wright, J.T. Parker, J.C.H. Birbeck and K.P. Hilton, Appl. Phys. Lett., Vol. 61, No. 15, pp. 1754-1756, 1992 and "Waveguide Beam Splitters And Recombiners Based On Multiple Propagation Phenomena" by R.M. Jenkins, R.W.J. Debereax and J.M. Heatan, Optics Lett., Vol. 17, No. 14, pp. 991-993, 1992, hereby incorporated by reference.

An important aspect of the invention is that the multimode waveguide in accordance with the present invention is formed as an active device to provide optical gain, in addition to optical signal splitting. As shown in Figure 1, the optical signal splitter 20 includes an input single mode waveguide 24, a multimode waveguide gain cavity 28 of length Λ/N, where Λ is the symmetric mode self-imaging distance and N is the number of signal outputs, and a plurality of output single mode waveguides 26. An electrical contact (shown shaded in Fig. 1) is formed on the multimode gain cavity 28 to allow for current pumping in order to provide upfront gain to reduce signal noise and improve the saturation performance of the device. Optionally an electrical contact stub 29 may be coupled to the electrical contact formed on the multimode gain cavity 28 to facilitate external connections to the device in certain applications. The optical signal splitter 20 may be formed with an input single mode waveguide 24 that may be 3 microns wide and 0.1 mm long, and coupled to an active multimode waveguide gain cavity 28 that may be formed to have a length, Λ, of about 1.26 mm and a width, W of about 62 microns for operation at 1.3 µm optical wavelength in InP/InGaAsP materials, and a plurality of output waveguides 26 to which the output of the active multimode waveguide splitter is coupled.

The output of the multimode waveguide 28 is monolithically coupled to a plurality of single mode waveguides 32, 34, 36, 38, 40, 42, 44 and 46. The single mode waveguides of the device may be divided into three regions; a first passive waveguide region 48, an active waveguide region 50 and a second passive waveguide region 52. The first passive waveguide region 48 is, for example, 2.75mm long while the active waveguide region 50 is 0.5mm long and the second passive waveguide region 52 is 3.39mm.

A plurality of electrical contacts 54, 56, 58, 60, 62, 64, 66 and 68 may be aligned and coupled to the single mode waveguides 32, 34, 36, 38, 40, 42, 44 and 46 in the active waveguide region 50. The contacts 54, 56, 58, 60, 62, 64, 66 and 68 allow for current pumping of the single mode waveguides 32, 34, 36, 38, 40, 42, 44 and 46 to provide individual on individual amplitude control of the N output signals.

An important aspect of the invention relates to the active multimode waveguide 28 used to compensate for optical signal losses resulted from the splitting as well as provide improved saturation performance. More particularly, conventional splitters, such as multimode splitters, for example, as shown in FIG. 3 are passive devices and require input signal preamplification. Unfortunately, the input signal pre-amplification is limited by the saturation power which approximates the upper limit on the maximum optical power before RF gain is reduced. To minimize the effect of signal shot noise, a signal is normally about 10 milliwatts or higher. If an optical preamplifier is used to compensate for splitting losses of a passive device, the output levels would be limited to a value of approximately 1/N times the saturation power for a 1 by N multimode splitter in order to prevent driving the preamplifier too strongly into saturation. However, this would require that the saturation power be N x 10 milliwatts to maintain the 10 milliwatts signal output levels. An important aspect of the invention is that the gain is supplied to the active multimode waveguide 28 such that the optical intensity never greatly exceeds the saturation intensity. Thus, the output signal levels can be made to approach the saturation power which would only need to be about 10 milliwatts to maintain 10 milliwatt signal outputs. With this geometry, the benefit of optical preamplification before splitting to N outputs is achieved without having to fabricate an optical amplifier with a saturation power N times higher than the desired output signal level, which needs to be 10 milliwatts or more to minimize shot noise.

An important consideration is that the pumping current must be kept to modest levels. More particularly, as is known in the art, a semiconductor with optical gain exhibits spatial hole burning as the optical power approaches saturation intensity. The multimode imaging may be affected by gain spatial hole burning depending on the magnitude of the linewidth enhancement factor α and the optical power in the amplifier. Typically, α ranges in value from 2 to 4 for most semiconductor gain media. In order for the device to operate properly, the optical gain must be kept at modest levels so that the optical intensity never exceeds the saturation intensity, which is required for good RF performance, and so that the effect of gain spatial hole burning on the multimode imaging will not seriously degrade the performance of the device.

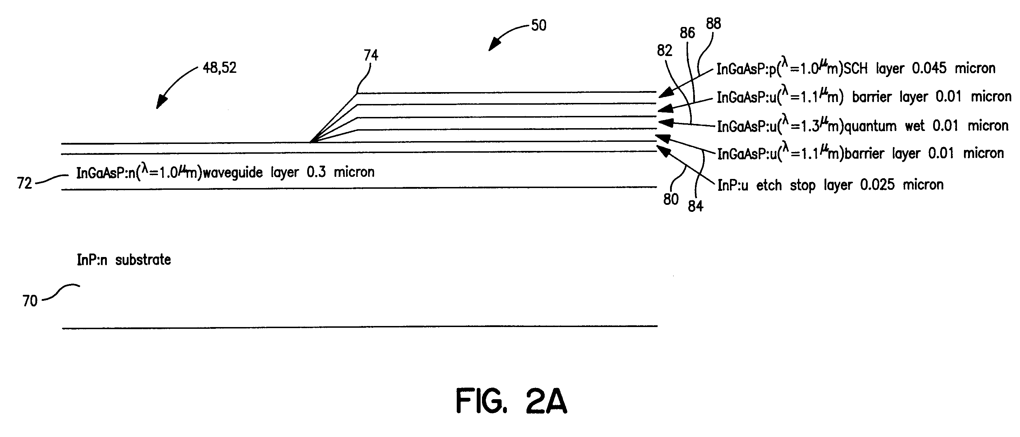

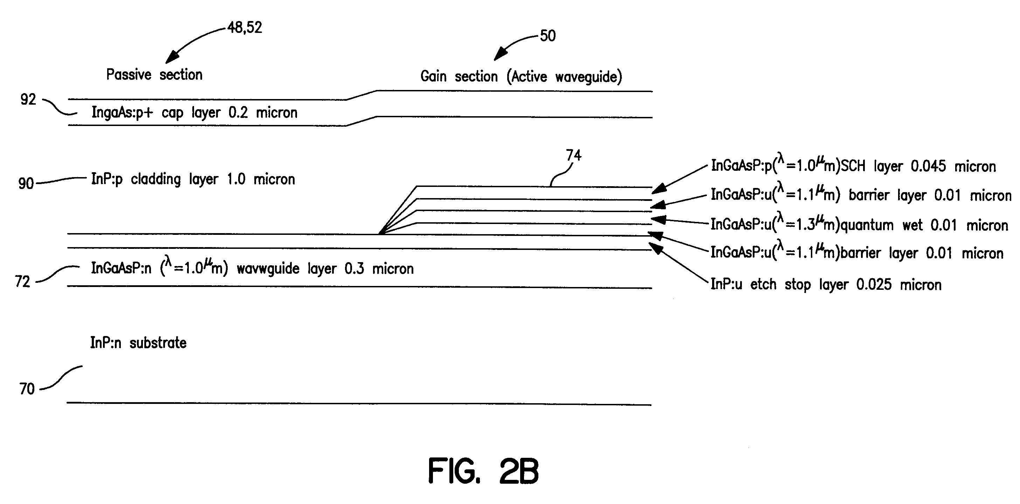

FIGS. 2a and 2b illustrate the process for fabricating the optical signal splitter 20 in accordance with the present invention. The fabrication of the optical signal splitter 20 may include a regrowth process required to integrate short active regions of semiconductor waveguides with passive waveguides as generally illustrated in FIGS. 2a and 2b. Other fabrication methods are also suitable, such as selective area epitaxy. In particular, referring first to FIG. 2a, the optical signal splitter 20 in accordance with the present invention may be formed on an n-doped substrate 70, such as an InP substrate. An n-doped waveguide layer 72, for example, InGaAsP, may be deposited on the substrate 70, for example by metal organic chemical vapor deposition (MOCVD) and epitaxially grown to a thickness of 0.3 microns. Subsequently, an active layer 74 may be deposited and grown on top of the waveguide layer 72 and selectively removed by etching in regions where the waveguide is passive (i.e. regions 48 and 52) in order to eliminate large absorption losses associated with an unpumped active layer in passive regions 48, 52. This etching process also forms the active regions 28 and 50 as generally illustrated in FIG. 2a. The various layers forming the active layer 74 may be deposited MOCVD, for example.

Since the passive regions 48, 52 are formed by etching the active layer 74 and subsequent regrowth, the active layer 74 is formed with an etch stop layer i.e., for example, an undoped InP with a thickness of 0.025 microns, deposited by MOCVD, for example. The active regions 28 and 50 of the waveguide is formed as a quantum well which includes quantum well layer 82 sandwiched between two barrier layers 84 and 86. The quantum well is deposited on top of the etch stop layer 80. The quantum well layer 82 as well as the barrier layers 84 and 86 may be formed from InGaAsP each having a thickness of about 0.01 microns. Another waveguide layer 88 is formed on top of the upper barrier layer 86, formed from, for example, 0.045 microns of SCH to optimize the transverse optical mode. As is known in the art, the quantum well layer 82 may be composed of a multi-quantum well structure, to provide more optical gain. This multi-quantum well structure is composed of 2 to 12 or more quantum well layers that alternate with barrier layers.

The active layer 74 is etched by conventional techniques to create the passive regions 48, 52. Afterwards an upper confinement layer 90 may be deposited by MOCVD or another technique and regrown, for example, on top of the etched structure. The confinement layer 90 may be a p-doped layer formed from In having a thickness of 1.0 microns. A cap layer 92 is formed from a P+doped InGaAs. Electrical contacts may then formed to be aligned with the active regions to provide for current injection and optical gain in those sections. The metal contacts 29, 54, 56, 58, 60, 62, 64, 66 and 68 may be formed by conventional photolithographic techniques.

Obviously, many modifications and variations of the present invention are possible in light of the above teachings. Thus, it is to be understood that, within the scope of the appended claims, the invention may be practiced otherwise than as specifically described above.

## Claims

1. An active multimode optical signal splitter which compensates for optical losses resulting from signal splitting comprising:
an active multimode, waveguide optical signal splitter for splitting and amplifying an input optical signal into N output optical signals; and
N single mode optical waveguides optically coupled to said multimode waveguide.

2. The active multimode optical signal splitter as recited in claim 1, wherein said N single mode optical waveguides are configured with one or more passive regions and an active region, said active region formed with an electrical contact coupled to each of N single mode waveguides for receiving a pumping current to allow for individual amplitude mode control of the N output signals.

3. The active multimode signal splitter as recited in claim 1, wherein said optical signal splitter is a multimode waveguide having a length equal to Λ/N, where Λ is the symmetric mode self-imaging distance and N is the number of output signals.

4. The active optical multimode signal splitter as recited in Claim 2, wherein said N single mode waveguides are configured such that a first passive region is optically coupled to said splitter.

5. The active optical multimode signal splitter as recited in Claim 4, wherein an active region of said N single mode waveguides is optically coupled to said first passive region.

6. The active optical multimode signal splitter as recited in Claim 5, wherein a second passive region is optically coupled to said active region.

7. The active optical multimode signal splitter is recited in claim 1, wherein said active multimode optical signal splitter is monolithically formed on a single substrate.

8. An active multimode optical signal splitter for compensating for optical losses due to signal splitting comprising:
an active multimode waveguide for optically splitting and amplifying an input optical signal to N output signals; and
a plurality of optical single mode waveguides, optically coupled to said optical signal splitter.

9. The active multimode optical signal splitter as recited in claim 8, wherein said single mode waveguides are formed with an integrated active region and one or more passive regions, said active region formed with electrical contacts in contact with said plurality of waveguides, said active and passive regions monolithically integrated with said multimode splitter.

10. A process for fabricating an active optical multimode signal splitter comprising the steps of:
(a) epitaxially growing a substrate layer, a waveguide layer and an active layer;
(b) etching said active layer to form one or more active and passive regions defined by an etched structure;
(c) forming a confinement layer on said etched structure; and
(d) forming electrical contacts aligned with said one or more active regions.

11. The process as recited in Claim 10, wherever said substrate layer is InP.

12. The process as recited in Claim 10, wherever said waveguide layer is InGaAsP.

13. The process as recited in Claim 10, wherein said active layer includes a quantum well sandwiched between a pair of barrier layers.

14. The process as recited in Claim 10, wherein said active layer includes a multiple quantum well structure sandwiched between a pair of barrier layers.

15. The process as recited in Claim 10, wherein said confinement layer is formed by regrowth.

16. The process as recited in Claim 10, wherein said confinement layer is formed by selective epitaxy.

17. The process as recited in Claim 10, wherein electrical contacts are formed by photolithography.
